# EUROPEAN PATENT APPLICATION

(11) **EP 3 940 785 A2**
(43) Date of publication of application: **19.01.2022**
(21) Application number: 21181731.7
(22) Date of filing: 25.06.2021
(51) Int. Cl.: H01L 27/32

(54) **DISPLAY DEVICE**

(30) Priority: 15.07.2020 KR 20200087558
(71) Applicant: Samsung Display Co., Ltd., Gyeonggi-do 17113 (KR)
(72) Inventor: Baek, In-Su, C-103 Seoul (KR); Lee, Joo Hyung, 205-403 113beon-gil, Suji-gu, Yongin-si, (KR); Kim, Min Ki, 415-1703 Hwaseong-si (KR); Kim, Young Gu, 234-201 Hwaseong-si, (KR); Chung, Min-Suk, 302, Seoul (KR)
(74) Representative: Dr. Weitzel & Partner

(57) **Abstract**

A display device includes a display panel including pixels, a first display area, and a second display area, and a metal layer disposed on a rear side of the display panel. The metal layer includes a light transmitting region disposed corresponding to the second display area. The light transmitting region includes a fine pattern.

## Description

### BACKGROUND

### 1. Technical Field

The disclosure relates to a display device for positioning an optical element on a rear side of the display device.

### 2. Description of the Related Art

A display device may include optical elements such as a sensor or a camera. To avoid interference with a screen, the optical element may be disposed in a non-display area (e.g., a bezel region surrounding the screen) of the display device.

When a non-display area such as the bezel of the display device is reduced, a ratio occupied by a display area increases when an electronic device including the display device is viewed from the front. A trend is occurring of gradually increasing a ratio of the display area of electronic equipment including the display device. However, when the non-display area such as a bezel is reduced from the display device, it may become difficult to dispose an optical element such as a sensor, so it may become desirable to develop a technology for positioning the optical element in the display area.

The above information disclosed in this Background section is only for enhancement of understanding of the background of the described technology, and therefore it may contain information that does not form the prior art that is already known in this country to a person of ordinary skill in the art.

### SUMMARY

The described technology has been made in an effort to provide a display device including a metal layer, with a light transmitting region at a position corresponding to an optical element, which is not deformed or is only slightly deformed when the light transmitting region may be formed.

The described technology has been made in effort to provide a display device for preventing an excessive force from being applied to a display panel when the metal layer may be attached to the display panel, or for preventing a light transmitting region made in the metal layer from being deformed.

An embodiment provides a display device that may include a display panel including a first display area and a second display area, and a metal layer disposed on a rear side of the display panel, the metal layer including a light transmitting region disposed corresponding to the second display area, wherein the light transmitting region may include a fine pattern. The rear side may be the side of the display panel which is opposite to the side displaying an image in the first (and/or second) display area. Thus, the rear side may be a side opposite to a light emitting side or to a pixel side including light emitting elements respectively pixels of the display panel. The "fine pattern" may be also termed as a "pattern" or as a "grid structure" in the metal layer, the grid structure for example comprising ridges (or lands) and openings between the ridges (lands). The ridges may be made of the same material as the surrounding part of the metal layer and may be integral with the surrounding part respectively may be one piece with the surrounding part. A fine pattern may be a ridge between two openings which may be adjacent to each other.

The light transmitting region may include a first fine pattern (or ridge/land) extending in a first direction, and an opening in a portion where the first fine pattern (ridge or land) may not be disposed. In other words, the light transmitting region of the metal layer may include at least one or several ridges (or first fine patterns) and at least one or several openings beside or between the ridges (first fine patterns). As a further alternative definition, the light transmitting region may include a grid structure with ridges and openings.

The first display area may include first pixel areas, and the second display area may include second pixel areas and transmission areas.

The first fine pattern may overlap a boundary of the second pixel areas and the transmission areas in a plan view.

The first fine pattern may include a densely arranged region and a scarcely arranged region in the light transmitting region. That is, the first fine pattern may include a comparatively densely arranged first region (dense region) and a comparatively less densely arranged second region (scarce region). In the first region there may be a higher number of ridges per unit area than in the second region. In the first region, the width of the ridges may be smaller than the width of the ridges in the second region. This may apply to ridges extending in a first direction and/or to ridges extending in a second direction which intersects the first direction or is perpendicular to the first direction.

The display device may further include an adhesive layer disposed on an internal side of the metal layer, the adhesive layer including an open region, wherein the open region of the adhesive layer may be wider than the light transmitting region and may overlap the light transmitting region in a plan view, and a boundary of the open region of the adhesive layer may be offset from a boundary of the light transmitting region. The internal side of the metal layer may be the side directed to or facing the display panel.

The display device may further include a protective film disposed on an exterior side of the metal layer, the protective film including an open region, wherein the open region of the protective film may be wider than the light transmitting region and may overlap the light transmitting region in a plan view, and a boundary of the open region of the protective film may be offset from the boundary of the light transmitting region. The exterior side of the metal layer may be the side facing away from the display panel.

The light transmitting region may further include a second fine pattern (which may also be called a second ridge) extending in a second direction intersecting the first direction.

The first display area may include first pixel areas, and the second display area may include second pixel areas and transmission areas.

The first fine pattern and the second fine pattern (respectively the first ridges and second ridges) may overlap a boundary of the second pixel areas and the transmission areas in a plan view.

The display device may further include an adhesive layer disposed on an internal side of the metal layer, the adhesive layer including an open region, wherein the open region of the adhesive layer may be wider than the light transmitting region and may overlap the light transmitting region in a plan view, and a boundary of the open region of the adhesive layer may be offset from a boundary of the light transmitting region.

The display device may further include a protective film disposed on an exterior side of the metal layer, the protective film including an open region, wherein the open region of the protective film may be wider than the light transmitting region and may overlap the light transmitting region in a plan view, and a boundary of the open region of the protective film may be offset from the boundary of the light transmitting region.

The display device may further include a polarizer disposed on a side of the display panel, and a window disposed on a side of the polarizer.

The display device may further include a bottom film disposed between the display panel and the metal layer.

Another embodiment provides a display device that may include a display panel including a first display area and a second display area, a metal layer disposed on a rear side of the display panel, the metal layer including a light transmitting region disposed corresponding to the second display area, and an adhesive layer disposed on an internal side of the metal layer, the adhesive layer including an open region, wherein the open region of the adhesive layer may be wider than the light transmitting region and overlap the light transmitting region in a plan view, and a boundary of the open region of the adhesive layer may be offset from a boundary of the light transmitting region.

The light transmitting region may include a first fine pattern extending in a first direction, and an opening in a portion where the first fine pattern may not be disposed. Regarding the first fine pattern the above-mentioned explanation with respect to the term ridge/land apply.

The light transmitting region may further include a second fine pattern (or second ridge) extending in a second direction intersecting the first direction.

The first display area may include first pixel areas, the second display area may include second pixel areas and transmission areas, and at least one of the first fine pattern and the second fine pattern (ridges) may overlap a boundary of the second pixel areas and the transmission areas in a plan view.

The display device may further include a protective film disposed on an exterior side of the metal layer, the protective film including an open region, wherein the open region of the protective film may be wider than the light transmitting region and may overlap the light transmitting region in a plan view, and a boundary of the open region of the protective film may be offset from the boundary of the light transmitting region.

The first fine pattern may include a densely arranged region and a scarcely arranged region in the light transmitting region.

According to embodiments, the metal pattern may be formed to be included in the light transmitting region of the metal layer positioned corresponding to the optical element, so the light transmitting region may not be deformed or may be only slightly deformed. Further, in case that there is little or no deformation around the light transmitting region of the metal layer and the metal layer is attached to the display panel, no damage may be generated to a partial region of the display panel.

Also, the adhesive layer positioned on the internal side of the metal layer may have an open region corresponding to a peripheral portion of the light transmitting region, and in case that the open region is offset to attach the metal layer to the display panel, the peripheral portion of the light transmitting region may not be allowed to press the display panel, so the display panel may not be damaged.

In case that the protective film positioned on the exterior side of the metal layer has an open region corresponding to the peripheral portion of the light transmitting region, the open region may be offset, the metal layer may be attached to the display panel, and the peripheral portion of the light transmitting region may not be deformed when pressure is applied from the outside.

### BRIEF DESCRIPTION OF THE DRAWINGS

FIG. 1 is a schematic top plan view of a display device according to an embodiment.
FIG. 2 is a schematic rear-side perspective view of a display device according to an embodiment.
FIG. 3 is a schematic lateral-side cross-sectional view of a display device according to an embodiment.
FIG. 4 is a schematic cross-sectional view of a display device according to an embodiment.
FIG. 5 is a schematic top plan view of a light transmitting region of a metal layer according to an embodiment.
FIG. 6 is an enlarged schematic view of a light transmitting region according to an embodiment of FIG. 5.
FIG. 7 is a schematic top plan view of a light transmitting region of a metal layer according to another embodiment.
FIG. 8 is a schematic top plan view of a light transmitting region of a metal layer according to another embodiment.
FIG. 9 is a schematic representation of deformation degrees of a peripheral portion of a light transmitting region according to a comparative example.
FIG. 10 and FIG. 11 are schematic representations of deformation degrees of a peripheral portion of a light transmitting region according to an embodiment.
FIG. 12 is a schematic rear-side perspective view of a display device according to another embodiment.
FIG. 13 is a schematic cross-sectional view of a display device according to another embodiment.
FIG. 14 is a schematic representation of attachment of a metal layer to a display panel.
FIG. 15 is a schematic top plan view of a metal layer and a peripheral layer according to another embodiment.
FIG. 16 is a schematic cross-sectional view of a metal layer and a peripheral layer according to an embodiment of FIG. 15.
FIG. 17 is a schematic top plan view of a metal layer and a peripheral layer according to another embodiment.
FIG. 18 is a schematic cross-sectional view of a metal layer and a peripheral layer according to an embodiment of FIG. 17.
FIG. 19 is a schematic view of a first display area, a second display area, and a light transmitting region of a display device according to an embodiment.
FIG. 20 is a schematic view of a first pixel area, a second pixel area, a transmission area, and a light transmitting region.
FIG. 21A - FIG. 21F are schematic representations of a pixel unit of a display device according to various embodiments.
FIG. 22 is a schematic circuit diagram of one pixel PX of a display device according to an embodiment.

### DETAILED DESCRIPTION OF THE EMBODIMENTS

The disclosure will be described more fully hereinafter with reference to the accompanying drawings, in which embodiments of the invention are shown. As those skilled in the art would realize, the described embodiments may be modified in various different ways, all without departing from the scope of the claims.

Parts that may be irrelevant to the description will be omitted to clearly describe the embodiments, and the same elements will be designated by the same reference numerals throughout the specification.

References to the singular (e.g., "a", "an", "the") should be construed to include plural forms where possible. Similarly, references to the plural should be construed to include singular forms where possible. In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/ or." The expression "at least one of" is intended to include the meaning of "at least one selected from the group of" for the purpose of its meaning and interpretation. For example, "at least one of A and B" may be understood to mean "A, B, or A and B."

The size and thickness of each configuration shown in the drawings may be arbitrarily shown for better understanding and ease of description, but the invention is not limited thereto. In the drawings, the thickness of layers, films, panels, regions, etc., may be exaggerated for clarity. The thicknesses of some layers and areas may be exaggerated for convenience of explanation.

It will be understood that when an element such as a layer, film, region, or substrate is referred to as being "on" another element, it can be directly on the other element or intervening elements may also be present. In contrast, when an element is referred to as being "directly on" another element, there may be no intervening elements present. The word "on" or "above" means disposed (e.g., "positioned") on or below the object portion, and does not necessarily mean positioned on the upper side of the object portion based on a gravitational direction.

Unless explicitly described to the contrary, words such as "comprise", "has", "have", and "include", and variations thereof, will be understood to imply the inclusion of stated elements but not the exclusion of any other elements.

The phrase "in a plan view" means viewing an object portion from the top, and the phrase "in a cross-sectional view" means viewing a cross-section of which the object portion is vertically cut from the side.

Throughout the specification, when it is described that a part is "connected (in contact with, coupled)" to another part, the part may be "directly connected" to the other element, may be "connected" to the other part through a third part, or may be connected to the other part physically or electrically, and they may be referred to by different titles depending on positions or functions, but respective portions that are substantially integrated into one body may be connected to each other.

The term "overlap" may include layer, stack, face or facing, extending over, extending under, covering or partly covering or any other suitable term as would be appreciated and understood by those of ordinary skill in the art. The expression "not overlap" may include apart from or set aside from or offset from and any other suitable equivalents as would be appreciated and understood by those of ordinary skill in the art.

"About", "approximately" or "substantially" as used herein may be inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within, for example, ± 30%, 20%, or 5% of the stated value.

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

An emissive display device of a display device according to an embodiment will now be described with reference to accompanying drawings.

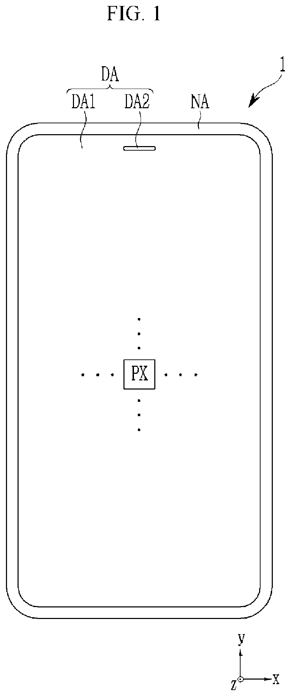

A configuration of a display device according to an embodiment will now be described with reference to FIG. 1 to FIG. 3.

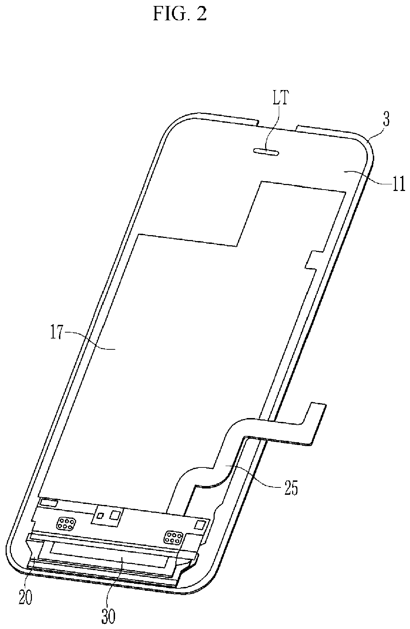

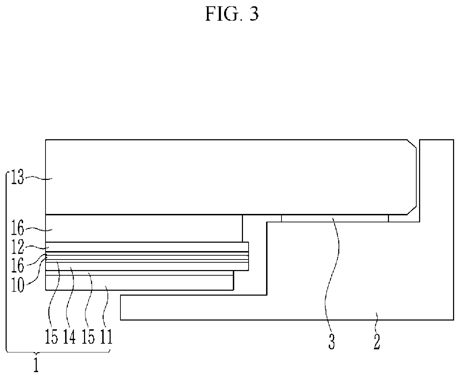

FIG. 1 is a schematic top plan view of a display device according to an embodiment, FIG. 2 is a schematic rear-side perspective view of a display device according to an embodiment, and FIG. 3 is a schematic lateral-side cross-sectional view of a display device according to an embodiment.

The display device 1 may include a display panel 10, and the display panel 10 may include a display area (DA) including pixels PX for displaying images and a non-display area (NA) adjacent to (e.g., surrounding) the display area (DA) and displaying no images.

Pixels PX may be positioned in the display area (DA), and one pixel PX may be distinguished into a light emitting element (also referred to as a light emitting diode (LED)) and a pixel circuit portion for supplying a current to the light emitting element.

Referring to FIG. 1, the display area (DA) may include a first display area DA1 and a second display area DA2.

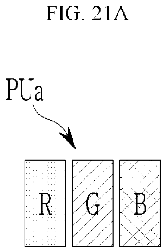

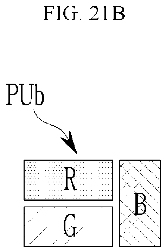

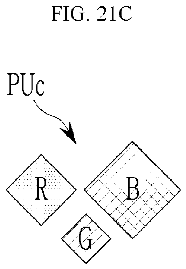

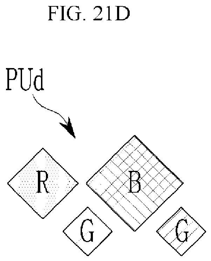

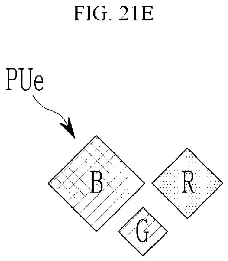

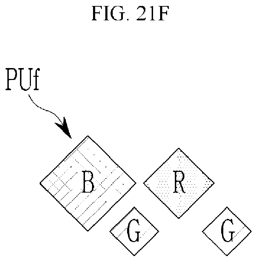

The first display area DA1 represents a portion where pixels PX may be continuously disposed (e.g., "arranged".) The first display area DA1 may display images, and from among the pixels PX, pixel circuit portions may be continuously arranged along rows and columns, and light emitting elements may be arranged in various ways, which may be described with reference to FIG. 21 below.

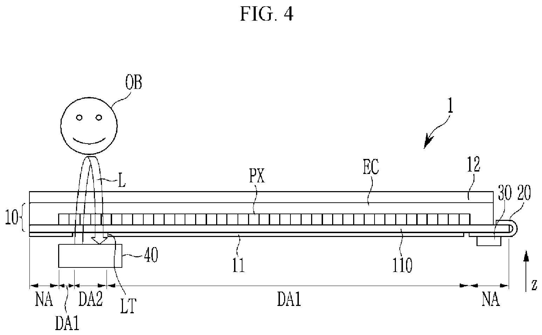

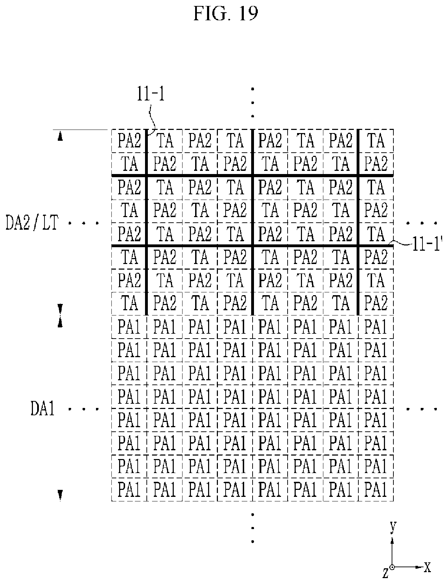

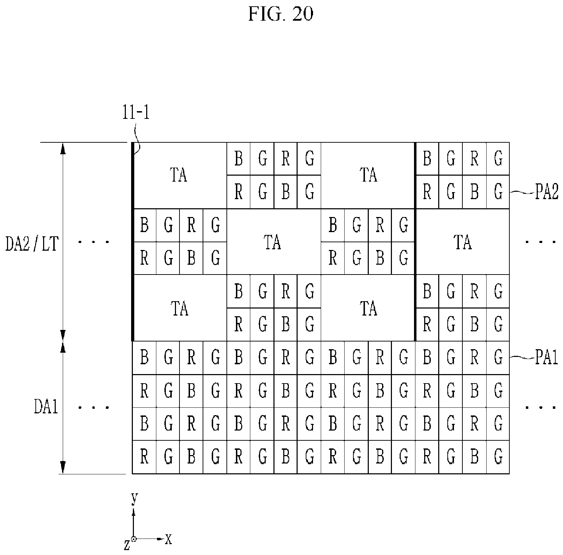

The second display area DA2 may perform a function of displaying an image, and perform an additional function of transmitting beams so that an optical element (40; refer to FIG. 4) positioned on the rear side of the display panel 10 may be operable. For example, the second display area DA2 may represent a region in which a space (transmission area TA; refer to FIG. 19 and FIG. 20) that may be empty without formation of a pixel PX may be further formed among pixels PX. As a result, the second display area DA2 may have higher transmittance than the first display area DA1 so that it may perform other functions in addition to the image display function. Here, the transmittance may signify transmittance of light through the display panel 10 in a third direction (z), and the light may include visible rays, infrared rays, and ultraviolet rays. The second display area DA2 may have a lower density of pixels PX, for example, a number of pixels PX per unit area, than the first display area DA1.

In the display area (DA), a shape, a position, and a size of the second display area DA2 may be variable. For example, differing from the shape of the second display area DA2 described with reference to FIG. 1, it may have various polygonal shapes such as a circle or a quadrangle. Further, a portion in which the second display area DA2 may be positioned may be, e.g., positioned near a peripheral portion of the display area (DA) or a center thereof from among the entire display area (DA). Embodiments may differ from those shown, e.g., in FIG. 1. For example, a number of second display areas DA2 may be plural, and an extending direction may be along the y axis.

Referring to FIG. 1, the second display area DA may be positioned in the first display area DA1 and may be surrounded by the first display area DA1. However, according to embodiments, it may be positioned on an outer side of the first display area DA1, and the second display area DA2 may be surrounded by the first display area DA1 and the non-display area (NA).

Regarding each pixel PX, signal lines such as a scan line, a data line, and a driving voltage line may be electrically connected to the pixel PX. The signals lines may receive a gate signal, a data voltage, and a driving voltage, respectively, and the pixel circuit portion may transmit a current to the light emitting element so that the light emitting element may emit light.

Signal lines for transmitting various signals and voltages applied to pixels PX may be disposed to extend in the non-display area (NA), and a driver for generating a signal applied to the pixel PX may be positioned depending on embodiments. The driver may be provided with a same process as the pixel PX or may be provided by attaching an additional IC chip.

In detail, the driver positioned in the non-display area (NA) may include a data driver for applying a data voltage to the data line, a scan driver for applying a scan signal to the scan line, and a signal controller for controlling the data driver and the scan driver. The scan driver may be integrated with the display panel 10, and may be positioned on respective sides or a side of the display area (DA). The data driver and the signal controller may be mounted on a flexible printed circuit board 20 as an IC chip 30 and may be electrically connected to the display panel 10.

Referring to FIG. 2, the display device 1 may further include the flexible printed circuit board 20 connected to a first end of the display panel 10 and bent to the rear side of the display panel 10, and the IC chip 30 attached to the flexible printed circuit board 20.

The IC chip 30 may represent a driver that receives the signal from the outside, changes the same into a driving signal that may be appropriate for the pixel PX, and transmits the same to the pixel PX. The flexible printed circuit board 20 may further include a connector 25 to receive a signal from the outside.

As shown in FIG. 2, a metal layer 11 and an insulating layer 17 positioned on the rear side of the metal layer 11 may be positioned on the rear side of the display panel 10. The insulating layer 17 may include an insulating material such as graphite, and the insulating layer 17 may insulate and protect the metal layer 11 so that the metal layer 11 may not receive a current from the rear side.

A light transmitting region (LT) may be positioned on the metal layer 11, and the light transmitting region (LT) may be positioned on the rear side of the second display area DA2 of the display panel 10. In a plan view, the second display area DA2 may overlap the light transmitting region (LT), and the second display area DA2 and the light transmitting region (LT) may have substantially the same shape or area.

FIG. 2 shows a double-sided adhesive tape 3 along an external portion on the rear side of the display device 1. Referring to FIG. 3, the double-sided adhesive tape 3 may be attached to a frame 2 of an electronic device including the display device 1 and may be fixed thereto.

FIG. 3 shows a cross-sectional configuration of the display device 1.

Referring to FIG. 3, the display device 1 may further include various configurations at a top and a bottom of the display panel 10. According to an embodiment described with reference to FIG. 3, the display device 1 may further include a window 13, a polarizer 12, and a bottom film 14 in addition to the display panel 10 and the metal layer 11.

The polarizer 12 may be further included at the top of the display panel 10, and the polarizer 12 may prevent light input from the outside from being reflected by an upper layer of the display panel 10 and being visible. Depending on embodiments, a phase delay layer may be further included on the polarizer 12. The display panel 10 and the polarizer 12 may be attached by a first adhesive layer 16.

Further, the window 13 for protecting the display panel 10 may be positioned at the top of the polarizer 12, and the window 13 may include a material such as plastic, glass, or a combination thereof. The polarizer 12 and the window 13 may be attached by the first adhesive layer 16.

Here, the first adhesive layer 16 may be positioned on a side of the display panel 10, and an adhesive material with high transmittance of light of the visible ray region output by the pixel PX of the display panel 10 may be used. The transmittance may be influenced by a difference of transmittance on the respective boundaries, so the first adhesive layers 16 positioned between the polarizer 12 and the display panel 10 and between the window 13 and the polarizer 12 may include different materials.

The bottom film 14 for protecting the rear side of the display panel 10 may be further included between the metal layer 11 and the rear side of the display panel 10 on the rear side of the display panel 10. The bottom film 14 may be a layer for protecting the display panel 10 from impacts applied from the bottom, and may be attached to the display panel 10 by a second adhesive layer 15. The bottom film 14 may have a characteristic of absorbing light so that light output by the display panel 10 may not be transmitted to the outside or may display a black color.

The metal layer 11 may be attached to the rear side of the bottom film 14 by the second adhesive layer 15. The metal layer 11 may be made of a metal material such as stainless steel. A light transmitting region (LT) may be positioned on part of the metal layer 11 as shown in FIG. 2, so no light transmits except at the light transmitting region (LT).

A relationship among the light transmitting region (LT) positioned on the metal layer 11, the optical element 40, and the second display area DA2 will now be described with reference to FIG. 4.

FIG. 4 is a schematic cross-sectional view of a display device according to an embodiment.

When FIG. 4 is compared to FIG. 3, the window 13 and the bottom film 14 that may be attached to the top or bottom of the display panel 10 are omitted.

Referring to FIG. 4, the display device 1 may further include an optical element 40, and the display panel 10 may include a substrate 110 on which the pixel PX may be positioned in addition to the pixel PX included in the display area (DA), and an encapsulation layer (EC) for preventing inflow of moisture or air by covering the pixel PX. The substrate 110 and the encapsulation layer (EC) may be positioned in the display area (DA) and the non-display area (NA).

The substrate 110 may be made of a single-layered glass substrate in case that the substrate 110 is a glass substrate, but in case that the substrate 110 is made of a flexible material such as plastic or polyimide (PI), it may further include an insulating layer (e.g., a buffer layer or a barrier layer).

The metal layer 11 positioned on the rear side of the display panel 10 may include a light transmitting region (LT), and the light transmitting region (LT) may be positioned corresponding to the second display area DA2 and the optical element 40 of the display panel 10. The shape and the size of the light transmitting region (LT) may substantially correspond to the second display area DA2, and it may be smaller than the optical element 40. This may be because there may be no problem in the operation in case that a part (also referred to as a light input and output unit) for receiving or outputting light L from among the optical elements 40 may be positioned in the light transmitting region (LT) and the second display area DA2. For example, some (e.g., a region) of the optical element 40 may be positioned outside the light transmitting region (LT) and the second display area DA2.

Referring to FIG. 4, the light provided by the optical element 40 may pass through the light transmitting region (LT) of the metal layer 11 and the second display area DA2 of the display panel 10, the light may be reflected from an object (OB), and the light may be input to the optical element 40. Depending on embodiments, the optical element 40 may not emit light and may receive light reflected from the object (OB), or the optical element 40 may emit light and may not receive light. Light used by the optical element 40 may include visible rays, infrared rays, and ultraviolet rays.

Examples of the optical element 40 may include a sensor, a camera, and a flashlight. In case that the optical element 40 is a sensor, the optical element 40 may be a proximity sensor, an illuminance sensor, an infrared ray sensor, or an ultraviolet ray sensor.

Light with a wavelength used by the optical element 40 may be generated to pass through the display panel 10 with higher transmittance through the second display area DA2. For example, in case that light used by the optical element 40 is infrared rays, the second display area DA2 may be provided so that transmittance of the infrared rays may be high, and transmittance of the visible rays or the ultraviolet rays may be low. However, multiple optical elements 40 may be included depending on embodiments, and the wavelengths of light used may vary. The second display area DA2 may be made to have high transmittance on the light with various wavelengths.

Also, FIG. 4 shows that the metal layer 11 does not overlap the flexible printed circuit board 20, but depending on embodiments, the flexible printed circuit board 20 may be positioned on part of the rear side of the metal layer 11 and may overlap the same.

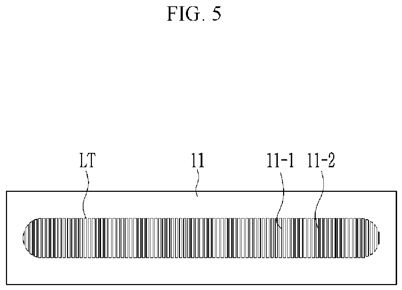

A detailed configuration and a characteristic of the light transmitting region (LT) positioned on the metal layer 11 will now be described with reference to FIG. 5 to FIG. 11.

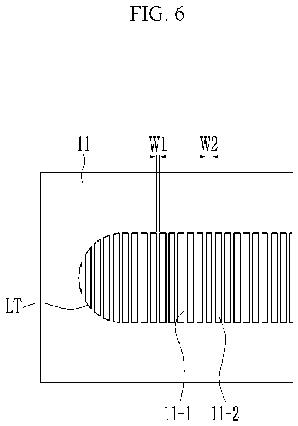

A configuration of the light transmitting region (LT) according to an embodiment will now be described with reference to FIG. 5 and FIG. 6.

FIG. 5 is a schematic top plan view of a light transmitting region of a metal layer according to an embodiment, and FIG. 6 is an enlarged schematic view of a light transmitting region according to an embodiment of FIG. 5.

Referring to FIG. 5, the light transmitting region (LT) of the metal layer 11 may include a fine pattern (11-1; a first fine pattern hereinafter) and openings (11-2) within the fine pattern 11-1. The fine pattern 11-1 may be made of a same material as the metal layer 11, and the fine pattern 11-1 may have a configuration in which a corresponding metal material may be removed in the opening 11-2.

The light transmitting region (LT) according to an embodiment may have a configuration in which a semi-circle shape may be formed at respective ends of a rectangle. However, a light transmitting region (LT) may have various configurations such as rectangular or circular depending on embodiments. The light transmitting region (LT) may have a width of about 5 mm to about 6 mm and a height of about 0.5 mm to about 0.7 mm, and a radius of the semicircle at the respective ends may be a half the height, for example, about 0.25 mm to about 0.35 mm. However, the light transmitting region (LT) may have various sizes depending on embodiments. Further, multiple light transmitting regions (LT) may be included according to embodiments.

A light transmitting region (LT) may correspond to multiple optical elements 40. In case that a semicircular configuration is added to the respective ends as described in an embodiment described with reference to FIG. 5, it may be appropriate for the case in which the part (a light input and output part) for outputting or receiving light in the optical element 40 has a circular configuration, and an optical element 40 having a circular configuration may be positioned on the respective ends of the light transmitting region (LT). There may be an advantage of minimizing an area of the second display area DA2 with a low resolution on the display panel 10.

The area, size, and shape of the entire light transmitting region (LT) may be modifiable in various ways according to the number of the optical elements 40 and the shape of the light input and output unit.

A configuration of the fine pattern 11-1 and the opening 11-2 positioned in the light transmitting region (LT) will now be described with reference to FIG. 6. The fine patterns 11-1 may also be termed as ridges, that is a fine pattern 11-1 is a ridge between two openings 11-2.

Referring to FIG. 6, the fine pattern 11-1 may be configured with multiple linear patterns extending in one direction (the y-axis direction, refer to FIG. 1). The width W1 of the fine pattern 11-1 in FIG. 6 may influence an aperture ratio of the light transmitting region (LT) and may be formed to be narrower than a width (W2; also referred to as a gap between fine patterns) of the opening. Depending on embodiments, the number of fine patterns 11-1 may be reduced in case that the width W1 of the fine pattern 11-1 may be large, and the number of the fine patterns 11-1 may increase in case that the width W1 of the fine pattern 11-1 may be small.

In case that the width W1 of the fine pattern 11-1 used in an embodiment is about 0.01 mm to about 0.03 mm, and the width W2 of the opening 11-2 is about 0.05 mm to about 0.1 mm, transmittance of the light transmitting region (LT) may become equal to or greater than a level. The width W1 of the fine pattern 11-1 and the width W2 of the opening 11-2 may be changeable in various ways depending on embodiments, and they may be determined in consideration of transmittance and a strain of the light transmitting region (LT).

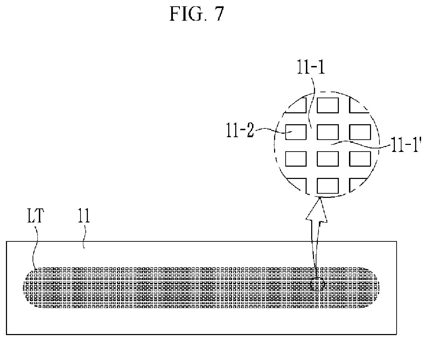

A light transmitting region (LT) according to another embodiment will now be described with reference to FIG. 7.

FIG. 7 is a schematic top plan view of a light transmitting region of a metal layer according to another embodiment.

In terms of the light transmitting region (LT) according to an embodiment of FIG. 7, the fine patterns (11-1 and 11-1') or ridges may extend in the horizontal and vertical directions, differing from an embodiment described with reference to FIG. 5. For example, the light transmitting region (LT) of the metal layer 11 according to an embodiment described with reference to FIG. 7 may include a first fine pattern 11-1 (or first ridge 11-1) extending in one direction (the y-axis direction, refer to FIG. 1), and a second fine pattern (11-1') (or second ridge 11-1') extending in one direction (the x-axis direction, refer to FIG. 1) that crosses or may be perpendicular to the first fine pattern 11-1. A portion on which the first and second fine patterns (11-1 and 11-1') may not be positioned may form an opening 11-2. The first and second fine patterns (11-1 and 11-1') may be made of the same material as the metal layer 11 and may be extended to each other at a crossing portion, so they have a configuration in which the corresponding metal material may be removed in the opening 11-2.

In an embodiment described with reference to FIG. 7, in a like manner of an embodiment described with reference to FIG. 5, the light transmitting region (LT) may have the width of about 5 mm to 6 about mm and the height of about 0.5 mm to about 0.7 mm, and the radius of the semicircle at the respective ends may be half the height, for example, about 0.25 mm to about 0.35 mm. Further, the width of the fine patterns (11-1 and 11-1') of FIG. 7 may be, in a like manner of FIG. 5, about 0.01 mm to about 0.03 mm, and the width (also referred to as a gap between fine patterns) of the opening 11-2 may be about 0.05 mm to about 0.1 mm.

In case that the fine pattern (or ridges) according to an embodiment described with reference to FIG. 7 may be formed to have the same width and gap as an embodiment described with reference to FIG. 5, an embodiment described with reference to FIG. 7 may have a relative advantage that the strain around the light transmitting region (LT) may be reduced, but also may have a drawback that the aperture ratio may be lowered. The width and the gap of the fine pattern may need to be optimized by considering the advantage and the drawback.

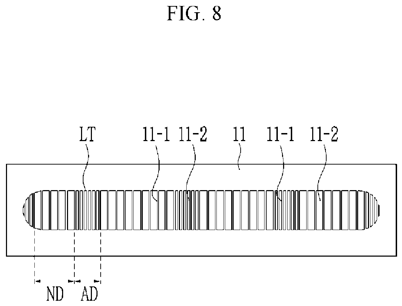

An embodiment described with reference to FIG. 5 to FIG. 7 shows that the fine patterns (11-1 and 11-1') may be disposed at a regular gap, but depending on embodiments, the fine patterns (11-1 and 11-1') may be densely disposed in a certain region and may be scarcely, that is less densely as compared to the certain region, disposed in the remaining region. An arrangement of the fine patterns (11-1 and 11-1') will now be described with reference to FIG. 8.

FIG. 8 is a schematic top plan view of a light transmitting region of a metal layer according to another embodiment.

FIG. 8 shows modification of a gap of the first fine pattern 11-1 in an embodiment described with reference to FIG. 5. In an embodiment described with reference to FIG. 8, the region may be divided into a region (hereinafter a dense region (AD) in which the first fine pattern 11-1 may be densely formed and a region (hereinafter a scarce region (ND)) in which the same may be scarcely formed.

According to an embodiment described with reference to FIG. 8, the dense region (AD) and the scarce region (ND) may be appropriately disposed, and the fine pattern 11-1 may be scarcely arranged on the position where the light input and output part of the optical element 40 may be disposed, thereby increasing light efficiency of the optical element 40 and reducing deformation of the peripheral portion of the light transmitting region (LT). For example, in an embodiment described with reference to FIG. 8, four optical elements 40 may be positioned corresponding to one light transmitting region (LT), and one optical element 40 may be positioned on each scarce region (ND) in which may be first fine pattern 11-1 may be scarcely provided, so four scarce regions (ND) and four optical elements 40 may be arranged one by one.

A dense region (AD) may be positioned in the region between the optical elements 40, and in FIG. 8, the dense regions (AD) may be positioned at the respective ends of the light transmitting region (LT). However, depending on embodiments, the scarce regions (ND) may also be positioned at the respective ends of the light transmitting region (LT).

In an embodiment described with reference to FIG. 8, the first fine patterns 11-1 positioned in the respective regions (ND and AD) may be provided with the same gap. However, depending on embodiments, the gap between the first fine patterns 11-1 may be different in the dense region (AD) and the scarce region (ND).

Further, differing from FIG. 8, the dense region (AD) and the scarce region (ND) may be formed in an embodiment described with reference to FIG. 7. A difference may be generated to the gap between the first fine pattern 11-1 and the second fine pattern (11-1'), so the size of the quadrangle configured by the opening 11-2 may vary.

The configuration of the fine pattern and the opening described with reference to FIG. 5 and FIG. 8 may be formed by processing the metal layer 11 by use of laser beams, or by etching the opening 11-2.

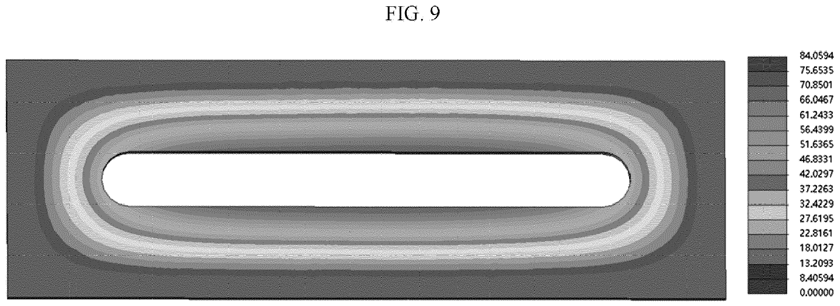

Deformation degrees according to a comparative example and an embodiment of FIG. 5 and FIG. 7 will now be described with reference to FIG. 9 to FIG. 11.

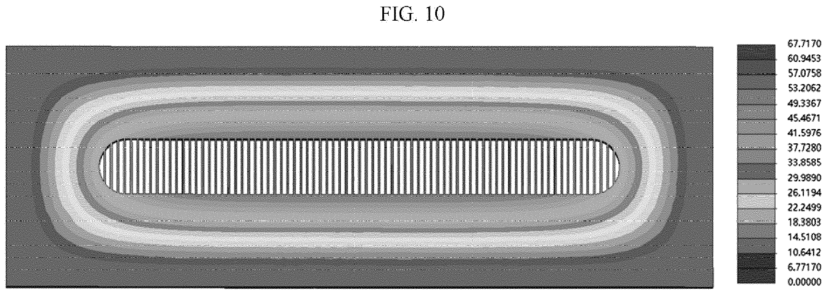

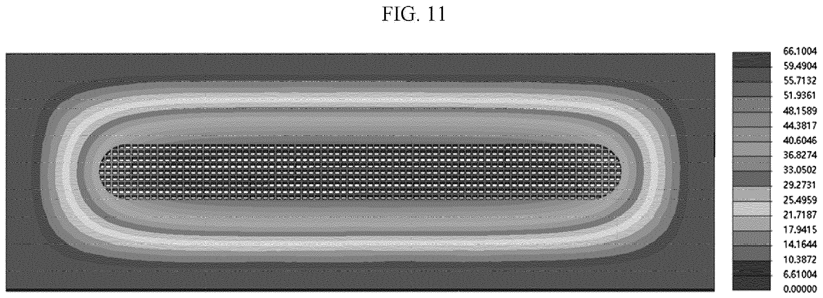

FIG. 9 is a schematic representation of deformation degrees of a peripheral portion of a light transmitting region according to a comparative example, and FIG. 10 and FIG. 11 are schematic representations of deformation degrees of a peripheral portion of a light transmitting region according to an embodiment.

FIG. 10 shows deformation degrees in an embodiment described with reference to FIG. 5, and FIG. 11 shows deformation degrees in an embodiment described with reference to FIG. 7. The comparative example described with reference to FIG. 9 has the same shape and size of the light transmitting region (LT) as an embodiment described with reference to FIG. 5 and FIG. 7, but includes no fine pattern, so the light transmitting region (LT) has a configuration formed of the opening.

Here, the width of the light transmitting region (LT) according to a comparative example and respective embodiments may be given as about 5.58 mm, the height thereof may beset to be about 0.6 mm, and the radius of the semicircle of the respective sides may be set to be about 0.3 mm. In an embodiment described with reference to FIG. 5 and FIG. 7, the width W1 of the fine pattern may be set to be about 0.02 mm, and the gap between the fine patterns, for example, the width W2 of the opening, may be set to be about 0.07 mm.

Regarding the comparative example and an embodiment, the embodiment has a low aperture ratio. For example, in case that the aperture ratio of the comparative example may be set to be 100 %, the aperture ratio of FIG. 5 may be about 71.5 %, and the aperture ratio of FIG. 7 may be lowered to be about 52.3 %.

However, in an embodiment, the peripheral strain of the light transmitting region (LT) may be low because of the fine pattern. For example, strain values for indicating the deformation degrees will now be compared. The strain value of the comparative example may be about 84.06, the strain value of an embodiment described with reference to FIG. 5 may be about 60.95, and the strain value of an embodiment described with reference to FIG. 7 may be 59.49, from which it may be found that an embodiment described with reference to FIG. 5 may be lower by about 27.5 % and an embodiment described with reference to FIG. 7 may be lower by about 29.2 % in comparison to the comparative example, so the strain may be low.

The strain may vary according to the position, so such a difference of strains is illustrated in FIG. 9 to FIG. 11 so that it may be confirmed by positions.

FIG. 9 shows that a great deformation may appear in the widest range, which includes no fine pattern, so it may be found that a great deformation may be generated on a center portion of the light transmitting region (LT).

In contrast, when FIG. 9 and FIG. 10 are compared, it may be found in an embodiment described with reference to FIG. 5 in which the deformation degrees may be substantially reduced, compared to the comparative example, which may be determined to be because appropriate control may be applied so that a deformation may be generated because of the fine pattern. Further, it may be found that, when the configuration shown in FIG. 11 may be compared to the comparative example described with reference to FIG. 9, the deformation degree may be substantially reduced.

Accordingly, at least one fine pattern may be provided to reduce deformation of the light transmitting region (LT) of the metal layer 11. Transmittance may decrease as the fine pattern may be added, so an embodiment for not reducing the transmittance by appropriately changing the number, width, and gap of the fine pattern may be provided. For example, as shown in FIG. 8, the fine pattern may be distinguished into a dense region and a scarce region to be appropriately arranged.

Regarding the configuration according to a comparative example described with reference to FIG. 9, an opening may be formed in the light transmitting region (LT) by pressing the metal layer 11 with a press, and when the press may be used, great deformation may be generated around the light transmitting region (LT).

In an embodiment, instead of forming the opening by pressing the metal layer with a press, the fine patterns (11-1 and 11-1') and the opening 11-2 may be formed on/in the metal layer 11 by processing the same by use of laser beams or by using an etching method. Particularly, the fine pattern must be formed in an embodiment, so it may not be easy to form the same by pressing the metal layer, and it may be a more appropriate method to form the same by using the laser beams or the etching method.

An aspect of the invention focusing on the deformation degree of the metal layer 11 including the light transmitting region (LT) has been described, and it may be found that an embodiment has less deformation than the comparative example.

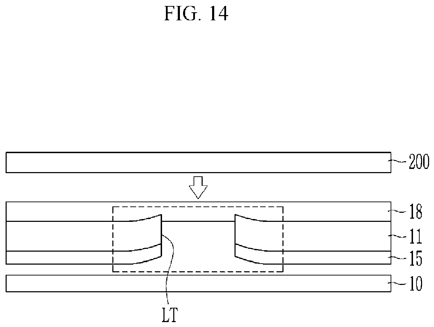

In general, when the metal layer 11 may be attached to the rear side of the display panel 10, a pressing jig 200 may be used as shown in FIG. 14. In this instance, the deformation degree of the metal layer 11 may be great so that there may be a protrusion, and as the rear side of the display panel 10 may be pressed, the display panel 10 may be damaged. However, in an embodiment, the metal layer 11 may be less deformed, so the display panel 10 may not be damaged in a next attaching process.

A method for preventing the display panel 10 or the metal layer 11 from being additionally damaged when the metal layer 11 may be attached to the rear side of the display panel 10 will now be described.

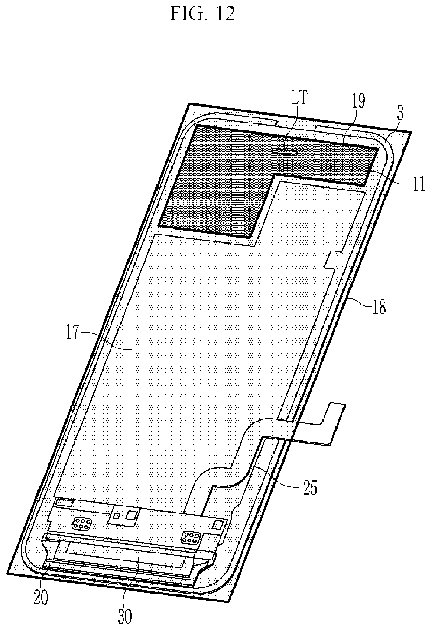

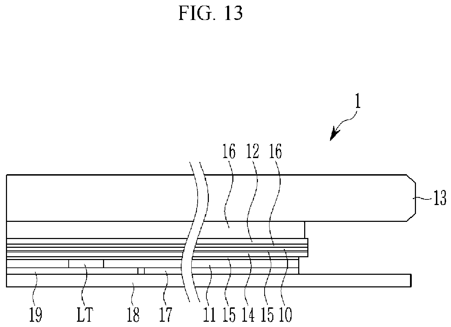

A modified configuration of the display device 1 will now be described with reference to FIG. 12 and FIG. 13.

FIG. 12 is a schematic rear-side perspective view of a display device according to another embodiment, and FIG. 13 is a schematic cross-sectional view of a display device according to another embodiment. FIG. 12 and FIG. 13 show no additional fine pattern in the light transmitting region (LT), but a fine pattern may be included in the light transmitting region (LT) in an embodiment.

FIG. 12 and FIG. 13 correspond to FIG. 2 and FIG. 3 respectively, and when compared to FIG. 2 and FIG. 3, a protective film 18 and a step removing member 19 may be further included on the rear side of the metal layer 11.

The step removing member 19 may be attached to an internal side of the protective film 18, and may be positioned corresponding to the region in which the insulating layer 17 may not be positioned on the rear side of the metal layer 11. Further, the step removing member 19 may have a thickness that corresponds to the thickness of the insulating layer 17. As a result, when the protective film 18 may be attached, the protective film 18 may be generally flat even when the insulating layer 17 may be on the rear side of the metal layer 11. In this instance, the light transmitting region (LT) of the metal layer 11 may be covered with the step removing member 19.

As shown in FIG. 12 and FIG. 13, the display device 1 may be sold while the protective film 18 and the step removing member 19 may be attached to the rear side, and an electronic equipment manufacturer having bought it may remove the protective film 18 and the step removing member 19 and may attach it to the frame 2 of the electronic equipment by using a double-sided adhesive tape 3 as shown in FIG. 2.

The metal layer 11 and the protective film 18 positioned on the rear side of the display panel 10 may be attached to the rear side of the completed display panel 10 by a pressurizing process, which will now be described with reference to FIG. 14.

FIG. 14 is a schematic representation of attachment of a metal layer to a display panel.

Although not shown in FIG. 14, a fine pattern may be positioned in the light transmitting region (LT).

FIG. 14 shows attachment of a metal layer 11 on which a second adhesive layer 15 may be positioned and a protective film 18 to a rear side of the display panel 10 by pressurizing them with a pressing jig 200.

In this instance, when a deformed portion may be positioned around the light transmitting region (LT) of the metal layer 11 and a pressure may be applied with the pressing jig 200, a region of the rear side of the display panel 10, for example, a rear portion of the display panel 10 corresponding to the deformed portion of the light transmitting region (LT), may be strongly pressurized and the corresponding portion may be damaged.

In case that there may be a problem when the metal layer 11 may be attached to the rear side of the display panel 10 as described above, an offset may be provided to the second adhesive layer 15 and/or the protective film 18 positioned at the top and the bottom of the metal layer 11 so that the rear side of the display panel 10 may not be pressed.

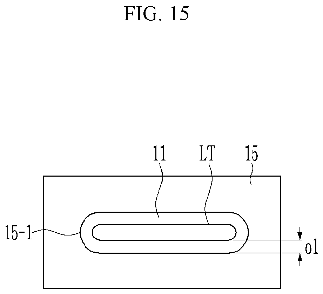

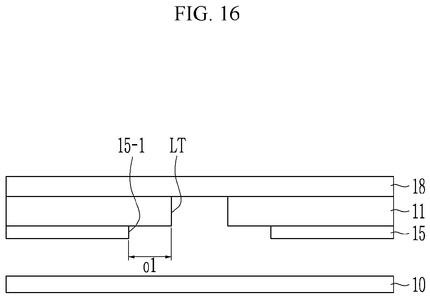

An embodiment for providing an offset to the second adhesive layer 15 will now be described with reference to FIG. 15 and FIG. 16.

FIG. 15 is a schematic top plan view of a metal layer and a peripheral layer according to another embodiment, and FIG. 16 is a schematic cross-sectional view of a metal layer and a peripheral layer according to an embodiment of FIG. 15.

FIG. 15 and FIG. 16 do not show a fine pattern in the light transmitting region (LT), but the fine pattern may be positioned in the light transmitting region (LT).

FIG. 15 shows a metal layer 11 and a second adhesive layer 15 positioned at the top thereof, in a plan view. The metal layer 11 may be partly deformed in the light transmitting region (LT) of the metal layer 11, and the second adhesive layer 15 may not be positioned on the deformed portion. As a result, a space (an open region; 15-1) in which the second adhesive layer 15 is opened may be positioned in a region that may be wider than the light transmitting region (LT). The open region 15-1 of the second adhesive layer 15 may include a light transmitting region (LT), and may include a deformed region adjacent to (e.g., around) the light transmitting region (LT) in a plan view.

Referring to FIG. 15 and FIG. 16, the second adhesive layer 15 positioned on the internal side of the metal layer 11 may include the open region 15-1, and the open region 15-1 of the second adhesive layer 15 may be wider than the light transmitting region (LT) and overlap the light transmitting region (LT) in a plan view, so part of the metal layer 11 may be exposed in the open region 15-1 of the second adhesive layer 15. A boundary of the open region 15-1 of the second adhesive layer 15 may be offset (o1) from a boundary of the light transmitting region (LT), the metal layer 11 may be exposed by the offset (o1) degree, and the exposed metal layer 11 may include a deformed region.

In an embodiment described with reference to FIG. 15 and FIG. 16, no open region may be provided on the protective film 18 positioned on a second side of the metal layer 11.

Referring to FIG. 16, when a pressure may be applied so as to attach the metal layer 11 to the rear side of the display panel 10, the second adhesive layer 15 may be offset (o1) and may not be positioned on the deformed portion around the light transmitting region (LT) of the metal layer 11. Therefore, when the deformed portion of the metal layer 11 is pressed, the display panel 10 may not be pressed, so the display panel 10 may not be damaged. As a result, the rear side of the display panel 10 may be protected even when the metal layer 11 may be deformed.

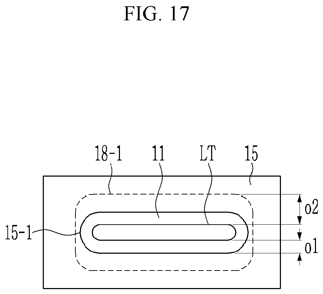

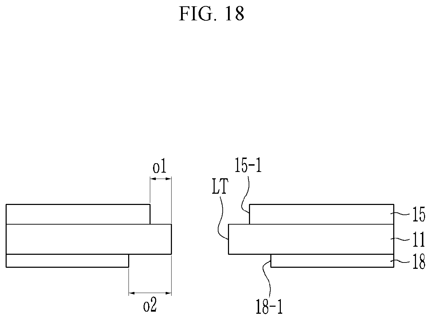

A provision of an offset to the second adhesive layer 15 and the protective film 18 according to an embodiment will now be described with reference to FIG. 17 and FIG. 18.

FIG. 17 is a schematic top plan view of a metal layer and a peripheral layer according to another embodiment, and FIG. 18 is a schematic cross-sectional view of a metal layer and a peripheral layer according to an embodiment of FIG. 17.

FIG. 17 and FIG. 18 do not illustrate a fine pattern in the light transmitting region (LT), but the fine pattern may be positioned in the light transmitting region (LT).

FIG. 17 shows a metal layer 11 and a second adhesive layer 15 positioned at the top thereof in a plan view, and a protective film 18 may be positioned at the bottom of the metal layer 11.

The metal layer 11 may be partly deformed around the light transmitting region (LT) of the metal layer 11, and the second adhesive layer 15 and the protective film 18 may not be positioned on the deformed portion.

For example, an open region 15-1 may be positioned in the second adhesive layer 15 corresponding to the region that may be wider than the light transmitting region (LT), and an open region 18-1 may be positioned in the protective film 18 corresponding to the region that may be wider than the light transmitting region (LT). The open region 15-1 of the second adhesive layer 15 and the open region 18-1 of the protective film 18 may include a light transmitting region (LT) in a plan view, and may include a deformed region around the light transmitting region (LT).

Referring to FIG. 17 and FIG. 18, the second adhesive layer 15 positioned on the internal side of the metal layer 11 may include an open region 15-1, the open region 15-1 of the second adhesive layer 15 may be wider than the light transmitting region (LT) and overlap the light transmitting region (LT) in a plan view, and part of the metal layer 11 may be exposed in the open region 15-1 of the second adhesive layer 15. The boundary of the open region 15-1 of the second adhesive layer 15 from the boundary of the light transmitting region (LT) may be offset (o1), the metal layer 11 may be exposed by the offset (o1) degree, and the exposed metal layer 11 may include a deformed region. Further, the protective film 18 positioned on the exterior side of the metal layer 11 may include an open region 18-1, and the open region 18-1 of the protective film 18 may be wider than the light transmitting region (LT) and overlap the light transmitting region (LT) in a plan view, so part of the metal layer 11 may be exposed in the open region 18-1 of the protective film 18. The boundary of the open region 18-1 of the protective film 18 from the boundary of the light transmitting region (LT) may be offset (o2), the metal layer 11 may be exposed by the offset (o2) degree, and the exposed metal layer 11 may include a deformed region.

Referring to FIG. 18, when pressed with the pressing jig 200 from the top, the light transmitting region (LT) of the metal layer 11 may not be directly pressed because of the open region 18-1 of the protective film 18 according to an embodiment described with reference to FIG. 18. Accordingly, the metal layer 11 may not be additionally deformed. The open region 15-1 that may be offset (o1) may be positioned on the second adhesive layer 15, so when the deformed portion of the metal layer 11 may be pressed, the display panel 10 may not be pressed. As a result, the rear side of the display panel 10 may be protected even when the metal layer 11 may be deformed, and the metal layer 11 may not be additionally deformed.

A configuration in which the fine patterns (11-1 and 11-1') positioned in the light transmitting region (LT) may be arranged to not cross the transmission area TA positioned in the second pixel area DA2 will now be described with reference to FIG. 19 and FIG. 20.

FIG. 19 is a schematic view of a first display area, a second display area, and a light transmitting region of a display device according to an embodiment.

The first display area DA1 and the second display area DA2 of the display panel 10 will now be described.

FIG. 19 shows pixel areas PA1 and PA2 and a transmission area TA, the first display area DA1 includes a first pixel area PA1, and the second display area DA2 includes a second pixel area PA2 and a transmission area TA. The first pixel area PA1 and the second pixel area PA2 may have a same size and a same configuration.

In the first display area DA1, the first pixel area PA1 may be arranged in a matrix in a first direction (x) and a second direction (y) that may be different directions.

In the second display area DA2, the second pixel area PA2 and the transmission area TA may be arranged in a matrix. The second pixel area PA2 and the transmission area TA may be arranged in a checkerboard pattern so that the second pixel area PA2 and the transmission area TA may be uniformly mixed. For example, the transmission area TA may be positioned around one second pixel area PA2 in the first direction (x) and the second direction (y), and the second pixel area PA2 may be positioned around one transmission area TA in the first direction (x) and the second direction (y). At least one second pixel area PA2 and at least one transmission area TA may be alternately arranged in the first direction (x) and/or the second direction (y).

The second pixel area PA2 and the transmission area TA may have a same size or different sizes. Each of the transmission areas TA may have a same or different size. Further, disposal and sizes of the second pixel area PA2 and the transmission area TA may be modifiable in various ways. For example, in the second display area DA2, an area ratio of the second pixel area PA2 vs. the transmission area TA may be substantially 1:1 according to an embodiment, but the transmission area TA may be disposed with various area ratios such as substantially 1:3, substantially 1:7, or substantially 1:15. For example, the area ratio of the second pixel area PA2 vs. transmission area TA may be about 1:2n-1 (here, n may be a natural number).

The respective pixel areas PA1 and PA2 may include at least one pixel PX, or may include a pixel unit (PU: PUa, PUb, PUc, PUd, PUe, PUf) shown in FIG. 21A - FIG. 21F.

The pixel PX may include a pixel circuit portion and a light emitting element. The pixel circuit portion may be a circuit for driving a light emitting element such as a light emitting diode (ED), and may include a transistor and a capacitor. The light emitting element emits light according to a size of a current provided by the pixel circuit portion. The pixel PX shown in FIG. 19 may correspond to the pixel circuit portion. The pixel PX may emit light in a direction, for example, a third direction (z).

The light transmitting region TA and the second pixel area PA2 may be arranged in a regular form in the second display area DA2, so they may display images in a like manner of the first display area DA1, and the above-described optical element 40 may be positioned on the rear side to perform functions of the optical element 40 such as infrared sensing or illuminance sensing in addition to image display.

The transmission area TA may be configured with a light transmitting layer, and it may include at least one dummy pixel depending on embodiments. Here, the dummy pixel may not include a pixel circuit but may include an emitter, and it may receive a current from the adjacent pixel PX and may emit light.

The second display area DA2 of the above-described display panel 10 may correspond to the light transmitting region (LT) of the metal layer 11 in a plan view. FIG. 19 shows the second display area DA2 and the light transmitting region (LT) altogether, which may be because they overlap each other in a plan view, and the light transmitting region (LT) may be positioned on the metal layer 11 at the bottom and the second display area DA2 may be positioned on the display panel 10 in a cross-sectional view.

Further, the fine patterns (11-1 and 11-1') positioned in the light transmitting region (LT) may be disposed along the boundary of the second pixel area PA2 and the transmission area TA, and at least one second pixel area PA2 and/or a transmission area TA may be positioned between the adjacent fine patterns (11-1 and 11-1').

An embodiment described with reference to FIG. 19 may include the metal layer 11 according to an embodiment described with reference to FIG. 7, and two fine patterns (11-1 and 11-1') extending in two different directions may be provided. However, in a like manner of an embodiment described with reference to FIG. 5, the first fine pattern 11-1 may be included, and the second fine pattern (11-1') may not be included.

A red pixel (R), a green pixel (G), and a blue pixel (B) may be included in the pixel areas PA1 and PA2 of FIG. 19, and they may be arranged in various numbers and methods. Various embodiments on the red pixel (R), the green pixel (G), and the blue pixel (B) included in the pixel areas PA1 and PA2 will now be described with reference to FIG. 20 and FIG. 21.

A detailed configuration of the pixel areas PA1 and PA2 will now be described with reference to FIG. 20, and a display device including the metal layer 11 according to an embodiment described with reference to FIG. 5 will now be described.

FIG. 20 is a schematic view of a first pixel area, a second pixel area, a transmission area, and a light transmitting region.

Regarding the display panel 10 shown in FIG. 20, the first display area DA1 may include first pixel areas PA1, and the second display area DA2 may include second pixel areas PA2 and transmission areas TA. The size of one first pixel area PA1 may/may not correspond to the size of one second pixel area PA2.

The transmission area TA of the second display area DA2 may have higher transmittance of light (e.g., light with the infrared ray wavelength) with a specific wavelength than the second pixel area PA2. The light transmitting characteristic of the transmission area TA may be determined depending on which wavelength of light the optical element 40 positioned on the rear side uses.

In an embodiment, no pixel may be positioned in the transmission area TA, so no light of the image may be displayed. However, depending on embodiments, a dummy pixel in which a light emitting element may be provided may be positioned in the transmission area TA to receive the current from the adjacent pixel PX and emit light.

In an embodiment described with reference to FIG. 20, in a like manner of an embodiment described with reference to FIG. 19, regarding the first display area DA1, first pixel areas PA1 may be arranged as a matrix in the first direction (i.e., the x-axis direction) and the second direction (i.e., the y-axis direction), and regarding the second display area DA2, second pixel areas PA2 and transmission areas TA may be arranged as a matrix. The second pixel area PA2 and the transmission area TA may be arranged in a checkerboard pattern so that the second pixel areas PA2 and the transmission areas TA may be uniformly mixed. Further, one second pixel area PA2 and one transmission area TA may have the same or different sizes. The respective transmission areas TA may have the same or different sizes. The disposal and sizes of the second pixel area PA2 and the transmission area TA may be modified in various ways.

The light transmitting region TA and the second pixel area PA2 may be arranged in a regular form in the second display area DA2, so they may display images in a like manner of the first display area DA1, and the above-described optical element 40 may be positioned on the rear side to perform functions of the optical element 40 such as infrared sensing or illuminance sensing in addition to image display.

The first pixel area PA1 and the second pixel area PA2 may respectively include red pixels (R), green pixels (G), and blue pixels (B). Further, each of the red pixel (R), the green pixel (G), and the blue pixel (B) may include a pixel circuit portion and a light emitting element, and the rectangular configurations shown in FIG. 20 may represent pixel circuit portions of the respective red pixel (R), green pixel (G), and blue pixel (B). Arrangements of the light emitting elements of the respective red pixel (R), the green pixel (G), and the blue pixel (B) will be described in detail with reference to FIG. 21A - FIG. 21F.

The first pixel area PA1 and the second pixel area PA2 may respectively include a pixel unit, and one pixel unit may include at least one first pixel (R) for displaying a first color, a second pixel (G) for displaying a second color, and a third pixel (B) for displaying a third color.

In an embodiment described with reference to FIG. 20, one pixel unit (PU) may include one first pixel (R), two second pixels (G), and one third pixel (B), and one of the pixel areas PA1 and PA2 includes two pixel units. In this instance, the transmission area TA has a size that corresponds to eight pixels.

The second display area DA2 of the above-configured display panel 10 may correspond to the light transmitting region (LT) of the metal layer 11 in a plan view. FIG. 20 shows the second display area DA2 and the light transmitting region (LT) altogether, which may be because they overlap each other in a plan view, and the light transmitting region (LT) may be positioned on the metal layer 11 at the bottom and the second display area DA2 may be positioned on the display panel 10 in a cross-sectional view.

The fine pattern 11-1 positioned in the light transmitting region (LT) may be disposed along the boundary of the second pixel area PA2 and the transmission area TA, and at least one second pixel area PA2 and/or a transmission area TA may be positioned between fine patterns 11-1.

An embodiment described with reference to FIG. 20 may include the metal layer 11 according to an embodiment described with reference to FIG. 5, but it may further include a second fine pattern (11-1') extending in the y-axis direction in a like manner of an embodiment described with reference to FIG. 7.

FIG. 20 shows an embodiment in which a pixel unit includes four pixels (R, G, B, and G).

Various pixel units (PU) will now be described with reference to FIG. 21A - FIG.21F.

FIG. 21A - FIG. 21F are schematic representations of a pixel unit of a display device according to various embodiments.

FIG. 21A shows light emitting elements of a red pixel (R), a green pixel (G), and a blue pixel (B), and hatching may be additionally provided so as to distinguish from the pixel circuit portions of the respective pixels shown in other drawings. The respective light emitting elements of the red pixel (R), the green pixel (G), and the blue pixel (B) are illustrated to have quadrangular configurations, but in actual cases, respective corners may be formed to not be angulated but to be round.

As shown, a pixel unit may be configured with three pixels including one red pixel (R), one green pixel (G), and one blue pixel (B), or may be configured with four pixels including two of one color pixel (a green pixel (G) in an embodiment) thereof.

Referring to FIG. 21A, the light emitting elements of the respective red pixel (R), the green pixel (G), and the blue pixel (B) included by the pixel unit PUa according to an embodiment are illustrated to have the same size and shape (e.g., rectangular), and they may be arranged in one direction. In this instance, the light emitting element of each pixel may have the same arrangement as the pixel circuit portion.

Referring to FIG. 21B, the light emitting elements of the respective red pixel (R), the green pixel (G), and the blue pixel (B) included by the pixel unit PUb according to an embodiment may be rectangular. From among the light emitting elements of the red pixel (R), the green pixel (G), and the blue pixel (B), two light emitting elements, for example, the light emitting element of the red pixel (R) and the light emitting element of the green pixel (G), may be arranged to neighbor each other up and down, and the light emitting element of the blue pixel (B) may be perpendicularly lengthily disposed on one side of each of the light emitting element of the red pixel (R) and the light emitting element of the green pixel (G). The red light emitting element (R) and the green light emitting element (G) may be respectively lengthily disposed in the horizontal direction.

Referring to FIG. 21C, the light emitting elements of the respective red pixel (R), the green pixel (G), and the blue pixel (B) included by the pixel unit PUc according to an embodiment may substantially have a rhombus shape, and the light emitting element of the red pixel (R), the light emitting element of the green pixel (G), and the light emitting element of the blue pixel (B) may have different sizes. For example, the light emitting element of the blue pixel (B) may be the largest, and the light emitting element of the green pixel (G) may be the smallest.

The pixel unit PUd according to an embodiment described with reference to FIG. 21D may include a light emitting element of the red pixel (R), a light emitting element of the blue pixel (B), and two light emitting elements of the green pixel (G). The light emitting elements of the respective red pixel (R), green pixel (G), and blue pixel (B) included by the pixel unit PUd according to an embodiment may have a rhombus shape. The light emitting element of the red pixel (R), the light emitting element of the green pixel (G), and the light emitting element of the blue pixel (B) may have different sizes. For example, the light emitting element of the blue pixel (B) may be the biggest, and the light emitting element of the green pixel (G) may be the smallest.

FIG. 21E and FIG. 21F are modified embodiments of the embodiment described with reference to FIG. 21C and FIG. 21D, showing that the positions and the sizes of the light emitting element of the red pixel (R) and the light emitting element of the blue pixel (B) included in the pixel units PUe, PUf may be exchanged with each other.

There may be embodiments of various other pixel units not shown in FIG. 21A - FIG. 21F and arrangement methods of the light emitting elements of the red pixel (R), the green pixel (G), and the blue pixel (B), so they are not limited to the descriptions given with reference to FIG. 21A - FIG. 21F.

A configuration of a pixel PX included in the display panel 10 according to an embodiment will now be described with reference to a circuit diagram.

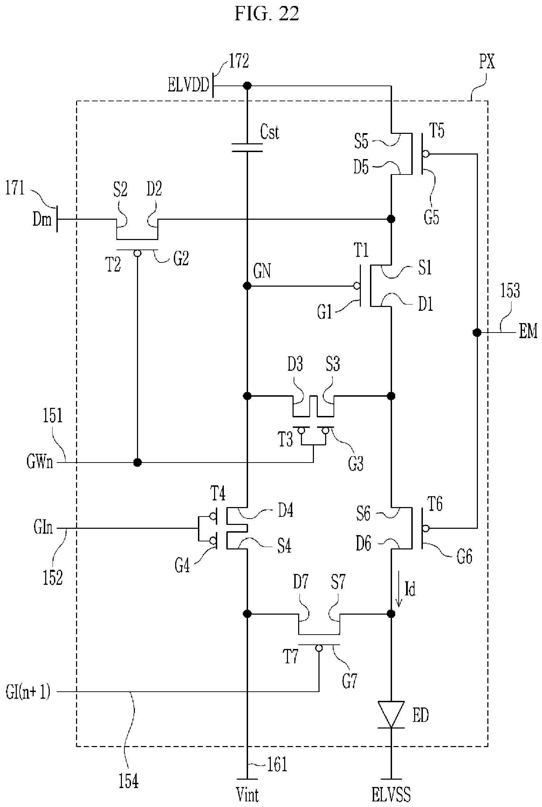

FIG. 22 is a schematic circuit diagram of a pixel PX of a display device according to an embodiment.

Referring to FIG. 22, one pixel PX may include transistors T1, T2, T3, T4, T5, T6, and T7 electrically connected to signal lines 151, 152, 153, 154, 161, 171, and 172, a capacitor Cst, and a light emitting diode (ED).

The signal lines 151, 152, 153, 154, 161, 171, and 172 may include scan lines 151, 152, and 154, an emission control line 153, a data line 171, a driving voltage line 172, and an initialization voltage line 161.

The scan lines 151, 152, and 154 may respectively transmit scan signals (GWn, GIn, and GI(n+1)). Regarding the scan signals (GWn, GIn, and GI(n+1)), a gate-on voltage and a gate-off voltage for turning on/off the transistors T2, T3, T4, and T7 may be alternately applied.

The scan lines 151, 152, and 154 electrically connected to a pixel PX may include a first scan line 151 for transmitting the first scan signal (GWn), a second scan line 152 for transmitting a second scan signal (GIn) with a gate-on voltage at a time that may be different from that of the first scan line 151, and a third scan line 154 for transmitting the third scan signal (GI(n+1)). The second scan line 152 may transmit the gate-on voltage at a time that may be prior to that of the first scan line 151. For example, in case that the first scan signal (GWn) may be an n-th scan signal from among the scan signals applied for a frame, the second scan signal (GIn) may be a previous-step scan signal such as an (n-1)-th scan signal, and the third scan signal (GI(n+1)) may be an n-th scan signal. The third scan signal (GI(n+1)) may be a scan signal that may be different from the n-th scan signal.

The emission control line 153 may transmit an emission control signal (EM) for controlling emission of the light emitting diode (ED). The emission control signal (EM) may include a gate-on voltage and a gate-off voltage for turning the transistors T5 and T6 on/off.

The data line 171 may transmit a data voltage (Dm). The driving voltage line 172 may transmit a driving voltage (ELVDD). The data voltage (Dm) may be generated based on an image signal input from the outside, and may have different voltage levels depending on luminance to be displayed by the light emitting element. The driving voltage (ELVDD) may have a substantially constant level. An initialization voltage (Vint) may be applied through the initialization voltage line 161, and the initialization voltage (Vint) may have a constant voltage level.

The display device may include driving devices (e.g., a scan driver, a light emission driver, a data driver, and a signal controller) for generating signals transmitted to the signal lines 151, 152, 153, 154, 161, 171, and 172.

The transistors T1, T2, T3, T4, T5, T6, and T7 included by a pixel PX may include a first transistor (T1; also referred to as a driving transistor), a second transistor T2, a third transistor T3, a fourth transistor T4, a fifth transistor T5, a sixth transistor T6, and a seventh transistor T7.

The first scan line 151 may transmit a first scan signal (GWn) to the second transistor T2 and the third transistor T3. The second scan line 152 may transmit a second scan signal (GIn) to the fourth transistor T4. The third scan line 154 may transmit a third scan signal (GI(n+1)) to the seventh transistor T7. The emission control line 153 may transmit an emission control signal (EM) to the fifth transistor T5 and the sixth transistor T6. The respective transistors T1, T2, T3, T4, T5, T6, and T7 may include source electrodes S1, S2, S3, S4, S5, S6, and S7, drain electrodes D1, D2, D3, D4, D5, D6, and D7, and gate electrodes G1, G2, G3, G4, G5, G6, and G7, and may include a polycrystalline semiconductor on which a channel may be provided.

The first transistor T1 may transmit the data voltage (Dm) transmitted to the source electrode S1 of the first transistor T1 from the second transistor T2 to a gate node (GN) through the third transistor T3. Here, the gate node (GN) may represent a node where the gate electrode G1 of the first transistor T1 and the capacitor Cst may be electrically connected. In case that a driving voltage (ELVDD) may be applied, the first transistor T1 may output a driving current (Id) and transmit it to the light emitting diode (ED) according to a voltage size of the gate node (GN).

The second transistor T2 may be turned on according to the first scan signal (GWn) transmitted through the first scan line 151, and transmit the data voltage (Dm) transmitted from the data line 171 to the source electrode S1 of the first transistor T1.

The third transistor T3 may be turned on according to the first scan signal (GWn) transmitted through the first scan line 151, and connect the gate electrode G1 of the first transistor T1 and the drain electrode D1 to diode-connect the first transistor T1 so that the data voltage (Dm) applied to the source electrode S1 of the first transistor T1 may be transmitted to the gate node (GN).

The fourth transistor T4 may be turned on according to the second scan signal (GIn) received through the second scan line 152, and transmit the initialization voltage (Vint) to the gate node (GN) to initialize a voltage at the gate electrode G1 of the first transistor T1 and the capacitor Cst (i.e., an initialization operation).

In case that the fifth transistor T5 and the sixth transistor T6 may be simultaneously turned on according to the emission control signal (EM) received through the emission control line 153 and apply the driving voltage (ELVDD) to the source electrode S1 of the first transistor T1, an output current of the first transistor T1 may be generated according to the voltage at the gate node (GN) and may be transmitted to the light emitting diode (ED).

The seventh transistor T7 may be turned on according to the third scan signal (GI(n+1)) received through the third scan line 154 to change the voltage at the anode of the light emitting diode (ED) to the initialization voltage (Vint).

The transistors T1, T2, T3, T4, T5, T6, and T7 may be p-type transistors, and at least one of the transistors T1, T2, T3, T4, T5, T6, and T7 may be an n-type channel transistor.

A first end of the capacitor Cst may be electrically connected to the gate electrode G1 of the first transistor T1, and a second end thereof may be electrically connected to the driving voltage line 172.

The anode of the light emitting diode (ED) may be electrically connected to the sixth transistor T6 to receive a driving current (Id), and the cathode thereof may be electrically connected to a common voltage (ELVSS) terminal for transmitting a common voltage (ELVSS) to receive the common voltage (ELVSS).

A number of transistors and a number of capacitors included by the pixel PX, and a connection relationship thereof, are modifiable in various ways.

An operation of the pixel PX according to an embodiment will now be described with reference to FIG. 22.

The pixel PX may be operable for an initialization period, a data programming and compensation period, and an emission period.

For the initialization period, in case that a second scan signal (GIn) of the gate-on voltage level may be supplied through the second scan line 152 (the second scan signal (GIn) may be an (n-1)-th scan signal), the fourth transistor T4 may be turned on to transmit the initialization voltage (Vint) to the gate electrode G1 of the first transistor T1 and to initialize the first transistor T1 by the initialization voltage (Vint).

For the data programming and compensation period, in case that the first scan signal (GWn) of the gate-on voltage level may be supplied through the first scan line 151 (the first scan signal (GWn) may be an n-th scan signal), the second transistor T2 and the third transistor T3 may be turned on. The first transistor T1 may be diode-connected by the turned-on third transistor T3. The data voltage (Dm) supplied through the data line 171 may be transmitted to the gate electrode G1 of the first transistor T1 through a diode-connected route, and the voltage at the gate electrode G1 of the first transistor T1 may gradually increase. In case that the voltage at the gate electrode G1 of the first transistor T1 becomes a small value from the data voltage (Dm) by a threshold voltage of the first transistor T1, the first transistor T1 may be turned off, and the voltage (Dm-Vth; here, Vth is a threshold voltage value of the first transistor T1) in this instance may be stored in the capacitor Cst.

For the emission period, the fifth transistor T5 and the sixth transistor T6 may be turned on by the emission control signal (EM) received through the emission control line 153. As a result, a driving current (Id) may be output from the first transistor T1 and may be transmitted to the light emitting diode (ED) according to a difference between the voltage at the gate electrode G1 of the first transistor T1 and the driving voltage (ELVDD). The light emitting diode (ED) may receive the driving current (Id) and emit light according to the size of the current.

For the data programming and compensation period, the seventh transistor T7 receives the third scan signal (GI(n+1)) through the third scan line 154 and may be turned on. As a result, the voltage at the anode of the light emitting diode (ED) may be changed to the initialization voltage (Vint) and may be initialized. The third scan signal (GI(n+1)) may be an n-th scan signal. However, depending on embodiments, the seventh transistor T7 may be turned on for the initialization period, and in this instance, the same signal as the second scan line 152 may be applied to the third scan line 154.

Various types of pixels in addition to the pixel PX with the above-described circuit configuration may be formed on the display panel, depending on embodiments.

While this disclosure has been described in connection with what is considered to be practical embodiments, it is to be understood that the invention is not limited to the disclosed embodiments. Rather, the disclosure is intended to cover various modifications and equivalent arrangements included within the scope of the appended claims.

## Claims

1. A display device (1) comprising:
a display panel (10) including a first display area (DA1) and a second display area (DA2); and
a metal layer (11) disposed on a rear side of the display panel (10), the metal layer (11) including a light transmitting region (LT) disposed corresponding to the second display area (DA2),
wherein the light transmitting region (LT) includes a fine pattern (11-1, 11-1').

2. A display device (1) comprising:
a display panel (10) including a first display area (DA1) and a second display area (DA2);
a metal layer (11) disposed on a rear side of the display panel (10), the metal layer (11) including a light transmitting region (LT) disposed corresponding to the second display area (DA2); and
an adhesive layer (15) disposed on an internal side of the metal layer (11), the adhesive layer (15) including an open region (15-1), wherein
the open region (15-1) of the adhesive layer (15) is wider than the light transmitting region (LT) and overlaps the light transmitting region (LT) in a plan view, and
a boundary of the open region (15-1) of the adhesive layer (15) is offset from a boundary of the light transmitting region (LT).

3. The display device (1) of claim 1 or 2, wherein the light transmitting region (LT) includes:
a first fine pattern (11-1) extending in a first direction; and
an opening (11-2) in a portion where the first fine pattern (11-1) is not disposed.

4. The display device (1) of claim 3, wherein the first fine pattern (11-1) includes a densely arranged region (AD) and a scarcely arranged region (ND) in the light transmitting region (LT).

5. The display device (1) of claim 1, 3 or 4, when not dependent on claim 2, further comprising
an adhesive layer (15) disposed on an internal side of the metal layer (11), the adhesive layer (15) including an open region (15-1), wherein
the open region (15-1) of the adhesive layer (15) is wider than the light transmitting region (LT) and overlaps the light transmitting region (LT) in a plan view, and
a boundary of the open region (15-1) of the adhesive layer (15) is offset from a boundary of the light transmitting region (LT).

6. The display device (1) of at least one of claims 1 to 5, further comprising
a protective film (18) disposed on an exterior side of the metal layer (11), the protective film (18) including an open region (18-1), wherein
the open region (18-1) of the protective film (18) is wider than the light transmitting region (LT) and overlaps the light transmitting region (LT) in a plan view, and
a boundary of the open region (18-1) of the protective film (18) is offset from the boundary of the light transmitting region (LT).

7. The display device (1) of at least one of claims 3 to 6, wherein the light transmitting region (LT) further includes a second fine pattern (11-1') extending in a second direction intersecting the first direction.

8. The display device (1) of at least one of claims 1 to 7, wherein
the first display area (DA1) includes first pixel areas (PA1), and
the second display area (DA2) includes second pixel areas (PA2) and transmission areas (TA).

9. The display device (1) of claim 8, wherein the first fine pattern (11-1) and the second fine pattern (11-1') overlap a boundary of the second pixel areas (PA2) and the transmission areas (TA) in a plan view.

10. The display device (1) of at least one of claims 1 to 9, further comprising a polarizer (12) disposed on a side of the display panel (10), and
a window (13) disposed on a side of the polarizer (12).

11. The display device (1) of at least one of claims 1 to 10, further comprising a bottom film (14) disposed between the display panel (10) and the metal layer (11).
